# EUROPEAN PATENT APPLICATION

(11) **EP 4 459 681 A1**
(43) Date of publication of application: **06.11.2024**
(21) Application number: 22913589.2
(22) Date of filing: 28.09.2022
(51) Int. Cl.: H01L 31/0224, H01L 31/02

(54) **SOLAR CELL AND ELECTRODES THEREOF**

(30) Priority: 27.12.2021 CN 202111614565
(71) Applicant: LONGi Green Energy Technology Co., Ltd., Xi'an, Shaanxi 710100 (CN)
(72) Inventor: CAI, Yongan, Xi'an, Shaanxi 710100 (CN)
(74) Representative: Pfenning, Meinig & Partner mbB
(86) International application number: PCT/CN2022/122293
(87) International publication number: WO 2023/124324

(57) **Abstract**

A solar cell and an electrode thereof are provided. The electrode includes a bus electrode (10) and a collector electrode (20) intersecting with each other, where a width of the collector electrode at any point on the collector electrode (20) ranges from 5 µm to 30 µm; and a resistivity of each of the collector electrode (20) and the bus electrode (10) is less than or equal to 3×10⁻⁶ Ω·cm.

## Description

### CROSS-REFERENCE TO RELATED APPLICATIONS

This application claims priority to Chinese Patent Application No. 202111614565.5 field with the China National Intellectual Administration Property on December 27, 2021 and entitled "SOLAR CELL AND ELECTRODES THEREOF", which is incorporated herein by reference in its entirety.

### TECHNICAL FIELD

This application relates to the field of photovoltaic technologies, and in particular, to a solar cell and an electrode thereof.

### BACKGROUND

A solar cell mainly includes a cell and electrodes. The cell absorbs sunlight and converts the sunlight into electrical energy. The electrodes output a current generated by the cell to an external circuit.

When the electrodes are prepared on the cell through screen printing, a resistivity of a used silver paste generally ranges from 4×10⁻⁶ Ω·cm to 8×10⁻⁶ Ω·cm. To ensure that the prepared electrodes do not have excessively great resistance, electrodes having a large cross-sectional area need to be prepared through the screen printing. Due to the strong fluidity of the silver paste, a prepared collector electrode generally has a large width (at present, a minimum limit of the width is 30 µm). Such a wider collector electrode will block the sunlight, resulting in a low light absorption rate of the cell. It can be seen that, a collector electrode having a large width reduces the light absorption rate of the cell and reduces the conversion efficiency of the solar cell.

### SUMMARY

An objective of this application is to provide a solar cell and an electrode thereof, to provide a collector electrode having a small width.

According to a first aspect, this application provides an electrode of a solar cell. The electrode includes a bus electrode and a collector electrode intersecting with each other, where a width of the collector electrode at any point on the collector electrode ranges from 5 µm to 30 µm; and a resistivity of each of the collector electrode and the bus electrode is less than or equal to 3×10⁻⁶ Ω·cm.

When the foregoing technical solution is adopted, the width of the collector electrode at any point on the collector electrode included in the electrode ranges from 5 µm to 30 µm. Compared with a collector electrode having a width larger than 30 µm prepared through screen printing, the collector electrode in this application has a smaller width. Because the width of the collector electrode is small, blocking to sunlight can be greatly reduced, so that more sunlight can be incident onto a cell, thereby improving the conversion efficiency and an output power of the solar cell. Meanwhile, the resistivity of each of the collector electrode and the bus electrode is less than or equal to 3×10⁻⁶ Ω·cm. In other words, a material of each of the collector electrode and the bus electrode has good electrical conductivity. In the related art, a resistivity of a silver paste for the screen printing generally ranges from 4×10⁻⁶ Ω·cm to 8×10⁻⁶ Ω·cm. Compared with the screen printing, in this application, on one hand, a collector electrode having a smaller width (the width ranges from 5 µm to 30 µm) may be prepared, reducing blocking to the sunlight. On the other hand, because the resistivity of the collector electrode in this application is small, with the same width, the same conductive effect can be achieved when a thickness of the collector electrode in this application accounts for only 0.375 to 0.75 of a thickness of the collector electrode in the screen printing, so that the thickness of the collector electrode can be reduced. In this case, the process difficulty of preparing the collector electrode can be reduced and the preparation efficiency can be improved, and materials can be saved, reducing stress applied by the electrode to the cell, thereby reducing cracking of the cell. Based on the above, by using the electrode provided in this application, the conversion efficiency and the output power of the solar cell can be improved, and the process difficulty of preparing the collector electrode may be reduced, thereby improving the preparation efficiency, saving materials, and reducing cracking.

In some implementations, the width of the collector electrode at any point on the collector electrode ranges from 10 µm to 20 µm. Compared with a size of the collector electrode in the related art, the width of the collector electrode in this application is significantly reduced, so that the conversion efficiency can be improved based on the conversion efficiency of existing solar cells. A width of the bus electrode at any point on the bus electrode ranges from 30 µm to 400 µm.

In some implementations, a material of each of the collector electrode and the bus electrode includes one or more of silver, aluminum, or copper. In this case, the material of each of the collector electrode and the bus electrode has good electrical conductivity.

In some implementations, a ratio of a thickness to the width of the collector electrode at any point on the collector electrode ranges from 0.2 to 2. In this case, a narrow and high collector electrode may be formed, so that a collector electrode having a large cross-sectional area can be formed while a small width is ensured, thereby helping reduce the resistance of the collector electrode, and improving the conversion efficiency and the output power of the solar cell. In addition, the narrow and high collector electrode in this application can provide certain reflection for the sunlight, so that an absorption rate of the cell for the sunlight can be further improved. In addition, the thickness-to-width ratio falling within this range may ensure the structure stability of the electrode, thereby avoiding a problem of collapse of the electrode after long-time use.

In some implementations, each collector electrode includes a first section, a second section, and a third section that are consecutive, the second section is located between the first section and the third section, and a length of the second section of each collector electrode accounts for 75% to 85% of a total length of the collector electrode; and a width error of the second section of each collector electrode is less than or equal to 10%, where the width error is a percentage of a difference between a width of the collector electrode at any position on the collector electrode and a width average value of a section in which the position is located to the width average value of the section. In this case, the width error of the second section of the collector electrode is small, namely, a width error of a main body portion of the collector electrode is small, and the width of the collector electrode is consistent, so that the resistance and stress sudden changes of the collector electrode can be reduced, thereby ensuring constant stress and resistance of each collector electrode.

In some implementations, the width error of the second section of each collector electrode is less than or equal to 8%. In this case, the width error of the collector electrode is further reduced, so that the precision of the collector electrode can be further improved, ensuring constant stress and resistance of each collector electrode.

In some implementations, a width error of each collector electrode is less than or equal to 10%. In this case, for each collector electrode, both the main body portion (the second section) and the entire collector electrode have a small width error. That is, the width of the entire collector electrode is consistent.

In some implementations, widths of the collector electrode at all points on the collector electrode are the same. In this case, when the thickness of the collector electrode remains unchanged, because the widths of the collector electrode at all the points on the collector electrode are the same, it may be ensured that the resistance and stress at all the points on the collector electrode are consistent, thereby avoiding excessive current damage and uneven stress. Widths of the bus electrode at all points on the bus electrode are the same. In this case, when the thickness of the bus electrode remains unchanged, because the widths of the bus electrode at all the points on the bus electrode are the same, it may be ensured that the resistance and stress at all the points on the bus electrode are consistent, thereby avoiding excessive current damage and uneven stress.

In some implementations, a cross-sectional shape of the collector electrode is a triangle. In this case, the triangular collector electrode provides reflection for the incident sunlight, so that the collector electrode has a light trapping function, and the absorption rate for the sunlight is improved.

In some implementations, a cross-sectional shape of the collector electrode is a trapezoid, and a top surface of the collector electrode is an arc surface. In this case, width changes of the collector electrode at all the points on the collector electrode are small, and material coverage is good, so that problems such as a gate with poor contact can be avoided.

In some implementations, an angle exists between a side surface of the collector electrode and a cell along a length direction of the collector electrode. In this case, the side surface of the collector electrode is inclined relative to the cell. The inclined side surface of the collector electrode can support the collector electrode, thereby improving the stability of the collector electrode. Especially, when the collector electrode is narrow and thick, the stability of the collector electrode is relatively poor, and the inclined side surface may assist in fixing the collector electrode, thereby improving the stability of the collector electrode and reducing a probability that the collector electrode collapses.

In some implementations, a gap exists between every two adjacent collector electrodes along the same track, and a length of the gap ranges from 400 µm to 2000 µm.

In some implementations, each electrode is located on a cell having a textured surface. In this case, the collector electrode having a small width is combined with the textured surface, so that a light trapping function of the textured surface is combined while blocking to the sunlight is reduced, thereby further improving a light absorption rate of the cell.

In some implementations, the electrode is prepared through a sputtering, evaporation, or deposition process after a mask is adhered to a cell. In this case, the bus electrode and the collector electrode may be formed simultaneously through the processes, namely, there is no need to prepare the bus electrode and the collector electrode respectively in two processes. In addition, during preparation of the electrode through the processes, electrode materials are stacked layer by layer in the form of molecules. During formation of the electrode, the fluidity of the materials is small, so that a narrow and high collector electrode can be formed, and the precision of a size of each electrode can be improved.

According to a second aspect, this application provides a solar cell. The solar cell includes the electrode of a solar cell described in the first aspect or any implementation of the first aspect.

For beneficial effects of the solar cell provided in the second aspect, reference may be made to the beneficial effects of the electrode of a solar cell described in the first aspect or any implementation of the first aspect, and details are not described herein again.

The foregoing description is merely an overview of the technical solutions of this application. To understand the technical means of this application more clearly, implementation can be performed according to content of the specification. Moreover, to make the foregoing and other objectives, features, and advantages of this application more comprehensible, specific implementations of this application are particularly listed below.

### BRIEF DESCRIPTION OF THE DRAWINGS

To describe the technical solutions in the embodiments of this application or the related art more clearly, the accompanying drawings required for describing the embodiments or the related art are briefly described hereinafter. Apparently, the accompanying drawings in the following description show merely some embodiments of this application, and a person of ordinary skill in the art may obtain other accompanying drawings according to the accompanying drawings without creative efforts.

The accompanying drawings described herein are used to provide further understanding of this application, and form a part of this application. Schematic embodiments of this application and description about the exemplary embodiments are used to explain this application, and do not constitute an inappropriate limitation on this application. In the accompanying drawings:
FIG. 1 is a schematic diagram of an electrode structure and measurement points according to an embodiment of this application;
FIG. 2 is a schematic cross-sectional view of a bus electrode according to an embodiment of this application;
FIG. 3a and FIG. 3b are schematic cross-sectional views of a collector electrode according to an embodiment of this application;
FIG. 4 is a schematic diagram of a position relationship between a collector electrode and a cell according to an embodiment of this application;
FIG. 5 is a schematic two-dimensional structural diagram of a collector electrode under a scanning electron microscope according to an embodiment of this application;
FIG. 6 is a first schematic three-dimensional structural diagram of a collector electrode under a scanning electron microscope according to an embodiment of this application;
FIG. 7 is a second schematic three-dimensional structural diagram of a collector electrode under a scanning electron microscope according to an embodiment of this application;
FIG. 8 is a schematic two-dimensional structural diagram of a bus electrode under a scanning electron microscope according to an embodiment of this application;
FIG. 9a is a schematic three-dimensional structural diagram of a junction of a bus electrode and a collector electrode under a scanning electron microscope according to an embodiment of this application; and
FIG. 9b is a schematic two-dimensional structural diagram of a junction of a bus electrode and a collector electrode under a scanning electron microscope according to an embodiment of this application.

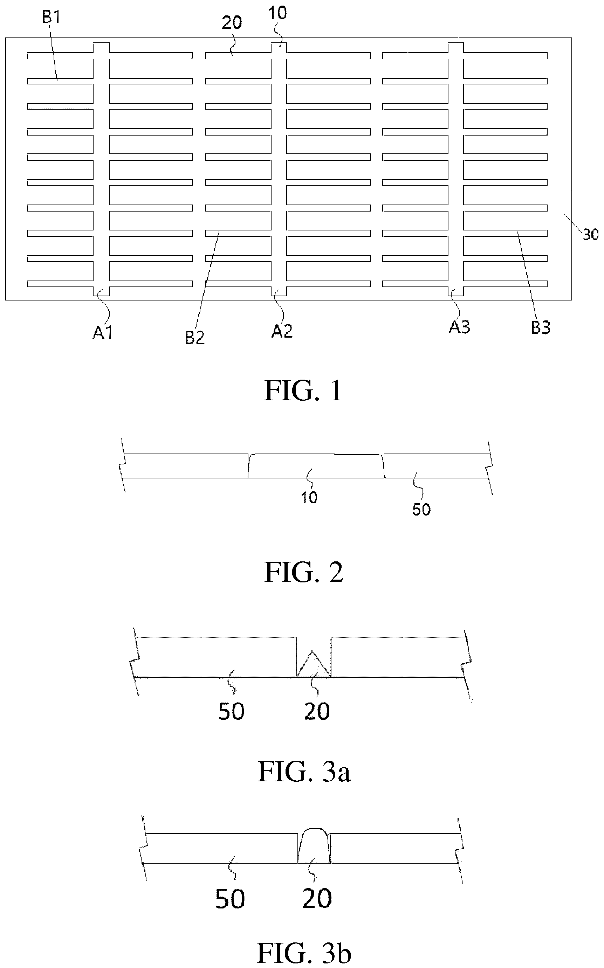

In FIG. 1 to FIG. 9b: 10-bus electrode, 20-collector electrode, 30-cell, and 50-mask.

### DETAILED DESCRIPTION

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are merely some embodiments of this application rather than all of the embodiments. Based on the embodiments in this application, all other embodiments obtained by a person of ordinary skill in the art without making creative efforts fall within the protection scope of this application.

For ease of describing the technical solutions in the embodiments of this application clearly, in the embodiments of this application, the terms such as "first" and "second" are used to distinguish same or similar items having a basically same function and role. A person skilled in the art may understand that the terms such as "first" and "second" do not limit a quantity and an execution sequence. In addition, the terms such as "first" and "second" do not indicate a definite difference.

It should be noted that, in this applications, the term such as "exemplary" or "for example" is used to represent giving an example, an illustration, or a description. Any embodiment or design scheme described as "exemplary" or "for example" in this application should not be explained as being more preferred or having more advantages than another embodiment or design scheme. Exactly, use of the term "exemplary" or "for example" is intended to present a related concept in a specific manner.

In this application, "at least one" means one or more, and "a plurality of" means two or more. "And/or" describes an association relationship between associated objects and represents that three relationships may exist. For example, A and/or B may represent the following three cases: Only A exists, both A and B exist, and only B exists, where A and B may be singular or plural. The character "/" generally indicates an "or" relationship between the associated objects. "At least one of the following" or a similar expression thereof refers to any combination of these items, including a single item or any combination of a plurality of items. For example, at least one of a, b, or c may indicate: a, b, c, a combination of a and b, a combination of a and c, a combination of b and c, or a combination of a, b, and c, where a, b, and c may be singular or plural.

During preparation of a solar cell, preparing electrodes on a cell is an important step. There are many processes for preparing the electrodes. When the electrodes are prepared on the cell through screen printing, a resistivity of a used silver paste generally ranges from 4×10⁻⁶ Ω·cm to 8×10⁻⁶ Ω·cm. To ensure that the prepared electrodes do not have excessively great resistance, an electrode having a large cross-sectional area needs to be prepared through the screen printing. Due to the strong fluidity of the silver paste, a prepared collector electrode generally has a large width (at present, a minimum limit of the width is 30 µm). Such a wider collector electrode will block sunlight, resulting in a low light absorption rate of the cell.

To resolve the foregoing technical problem, an embodiment of this application provide an electrode of a solar cell. As shown in FIG. 1, the electrode is located on a cell 30 of the solar cell. The electrode includes a bus electrode 10 and a collector electrode 20 intersecting with each other, where a width of the collector electrode at any point on the collector electrode 20 ranges from 5 µm to 30 µm; and a resistivity of each of the collector electrode 20 and the bus electrode 10 is less than or equal to 3×10⁻⁶ Ω·cm. It should be understood that in the embodiments of this application, a thickness is a length in a direction perpendicular to the cell 30; the width is a maximum size of a length of a smaller side of an orthographic projection pattern of each of the bus electrode 10 or the collector electrode 20 on the cell 30; and the length is a length of a larger side of the orthographic projection pattern of each of the bus electrode 10 or the collector electrode 20 on the cell 30, namely, an extension length of each of the bus electrode 10 or the collector electrode 20. A cross section is a cutting plane obtained by performing cutting along a direction perpendicular to the length of each of the bus electrode 10 or the collector electrode 20.

It may be learned from the foregoing electrode structure that, the width of the collector electrode at any point on the collector electrode 20 included in the electrode ranges from 5 µm to 30 µm. Compared with a collector electrode 20 having a width larger than 30 µm prepared through the screen printing, the collector electrode 20 in this application has a smaller width. Because the width of the collector electrode 20 is small, blocking to the sunlight can be greatly reduced, so that more sunlight can be incident onto the cell 30, thereby improving the conversion efficiency and an output power of the solar cell. Meanwhile, the resistivity of each of the collector electrode 20 and the bus electrode 10 is less than or equal to 3×10⁻⁶ Ω·cm. In other words, a material of each of the collector electrode 20 and the bus electrode 10 has good electrical conductivity. In the related art, a resistivity of a silver paste for the screen printing generally ranges from 4×10⁻⁶ Ω·cm to 8×10⁻⁶ Ω·cm. Compared with the screen printing, in this application, on one hand, a collector electrode 20 having a smaller width (the width ranges from 5 µm to 30 µm) may be prepared, reducing blocking to the sunlight. On the other hand, because the resistivity of the collector electrode 20 in this application is small, with the same width, the same conductive effect can be achieved when a thickness of the collector electrode 20 in this application accounts for only 0.375 to 0.75 of a thickness of the collector electrode in the screen printing, so that the thickness of the collector electrode 20 can be reduced. In this case, the process difficulty of preparing the collector electrode 20 can be reduced and the preparation efficiency can be improved, and materials can be saved, reducing stress applied by the electrode to the cell 30, thereby reducing cracking of the cell 30. For example, when the collector electrode 20 is prepared through the screen printing by using a silver paste with a resistivity of 6×10⁻⁶ Ω·cm, collector electrodes 20 having the same width are prepared, and if a thickness of the collector electrode 20 prepared through the screen printing is 20 µm, a collector electrode 20 having a thickness of 10 µm is prepared in the embodiments of this application to achieve the same conductive effect. Based on the above, by using the electrode provided in this application, the conversion efficiency and the output power of the solar cell can be improved, and materials may be saved, thereby reducing cracking.

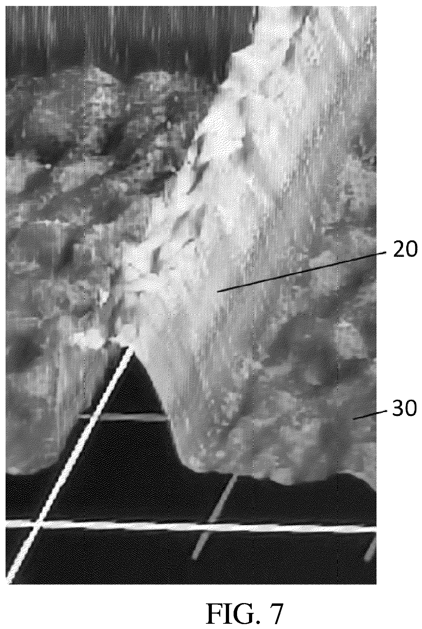

As shown in FIG. 1 and FIG. 5 to FIG. 7, the electrode is located on the cell 30 of the solar cell. Specifically, as shown in FIG. 7, the electrode may be located on a cell 30 having a textured surface. In this case, the collector electrode 20 having a small width is combined with the textured surface, so that a light trapping function of the textured surface is combined while blocking to the sunlight is reduced, thereby further improving a light absorption rate of the cell 30. During actual application, the cell 30 has a photoelectric conversion function and may be a crystalline silicon cell or an amorphous silicon cell. During actual application, a plurality of collector electrodes 20 may be distributed on the cell 30 in an array, and a plurality of bus electrodes 10 may vertically intersect with the plurality of collector electrodes 20.

As shown in FIG. 2 and FIG. 3, a manner of preparing the electrode may be implemented through a patterned mask 50, where patterned content is a plurality of slits on the mask 50. Specifically, the electrode is prepared through a sputtering, evaporation, or deposition process after the mask 50 is adhered to the cell 30. In this case, the bus electrode 10 and the collector electrode 20 may be formed simultaneously through the processes, namely, there is no need to prepare the bus electrode 10 and the collector electrode 20 respectively in two processes. In addition, during preparation of the electrode through the processes, electrode materials are stacked layer by layer in the form of molecules. During formation of the electrode, the fluidity of the materials is small, so that a narrow and high collector electrode 20 can be formed, and the precision of a size of the electrode can be improved.

During actual application, the mask 50 may be a mask 50 including a base film and an adhesive layer. The base film includes a polymer thin film. A material of the polymer film may be a high molecular polymer. Specifically, the high molecular polymer includes but is not limited to one or more of polyethylene terephthalate (PET), a polyolefin film (PO), polyimide (PI), polyvinyl chloride (PVC), biaxially oriented polypropylene (BOPP), or the like. Further, a material of the adhesive layer includes but is not limited to one or more of silicone, acrylic glue, polyurethane, rubber, polyisobutylene, or the like.

The slits may be formed on the mask 50 through laser grooving. Specifically, an ultra-fast pulsed laser with a picosecond-level or femtosecond-level pulse width may be used on the mask 50, and grooving may further be performed on the mask 50 by using a short pulsed laser with a microsecond-level or nanosecond-level pulse width, where the laser penetrates the base film and the adhesive layer of the mask 50 to form the slits.

During actual application, coordinate positions of the slits may be planned on the mask 50 in advance, and scribing and grooving are then performed at the planned coordinate positions of the slits by using the ultra-fast pulsed laser with a picosecond-level or femtosecond-level pulse width or the short pulsed laser with a microsecond-level or nanosecond-level pulse width, to form the slits and obtain the patterned mask 50.

It should be noted that, in combination with the foregoing description, the mask 50 needs to be designed to have a high absorption rate within a certain wavelength range, so that the mask 50 can efficiently absorb energy of a light source such as a laser in a process of performing patterning on the mask 50 using the light source such as the laser, thereby improving the energy utilization efficiency and the patterning precision. A detailed wavelength range needs to be designed according to a used light source.

For example, during preparation of the electrode, a mask 50 having a plurality of slit patterns and made of a PET film and a silicone layer may be aligned with and arranged on a front surface of the cell 30. Because the silicon layer is adhesive, the mask 50 may be adhered to the front surface of the cell, and the electrode is then prepared by using electrode materials through a sputtering, evaporation, or deposition process. In this process, a part of the electrode materials run through the slits of the mask 50 and fall onto the cell to form the collector electrode 20 and the bus electrode 10, and the other part of electrode materials fall on the mask 50 and are then removed together with the mask 50, to finally form the collector electrode 20 and the bus electrode 10 deposited on the front surface of the cell 30.

A resistivity of each of the collector electrode 20 and the bus electrode 10 is less than or equal to 3×10⁻⁶ Ω·cm. That is, any metal with a material resistivity not higher than 3×10⁻⁶ Ω·cm can be used as the material of each of the collector electrode 20 and the bus electrode 10. For example, the resistivity of each of the collector electrode 20 and the bus electrode 10 may be 3×10⁻⁶ Ω·cm, 2.8×10⁻⁶ Ω·cm, 2.6×10⁻⁶ Ω·cm, 2.4×10⁻⁶ Ω·cm, 2.2×10⁻⁶ Ω·cm, 2×10⁻⁶ Ω·cm, 1.8×10⁻⁶ Ω·cm, 1.6×10⁻⁶ Ω·cm, 1.5×10⁻⁶ Ω·cm, 1.3×10⁻⁶ Ω·cm, 1×10⁻⁶ Ω·cm, or the like.

Specifically, the material of each of the collector electrode 20 and the bus electrode 10 may include, but not limited to, one or more of silver, aluminum, or copper, and may further include one or more of nickel, chromium, tin, or titanium. In this case, the material of each of the collector electrode 20 and the bus electrode 10 has good electrical conductivity. For example, a thickness of the collector electrode 20 is 10 µm, and extending upward from a surface of the cell 30 in a direction perpendicular to the surface of the cell 30, namely, in a direction away from the cell 30, a part between 0 µm to 1 µm is a silver material layer, a part between 1.1 µm to 9 µm is an aluminum material layer, and a part between 9.1 µm to 10 µm is a copper material layer. Certainly, both the collector electrode 20 and the bus electrode 10 may be made of a single material. For another example, a thickness of the bus electrode 10 is 15 µm, and extending upward from the surface of the cell 30 in the direction perpendicular to the surface of the cell 30, namely, in the direction away from the cell 30, a part between 0 µm and 1 µm is a nickel material layer, a part between 1.1 µm to 12 µm is an aluminum material layer, and a part between 12.1 µm to 15 µm is a copper material layer. For another example, the thickness of the collector electrode 20 is 20 µm, and extending upward from the surface of the cell 30 in the direction perpendicular to the surface of the cell 30, namely, in the direction away from the cell 30, a part between 0 µm to 3.5 µm is a chromium material layer, a part between 3.6 µm to 15.5 µm is a copper material layer, and a part between 15.6 µm to 20 µm is a silver material layer.

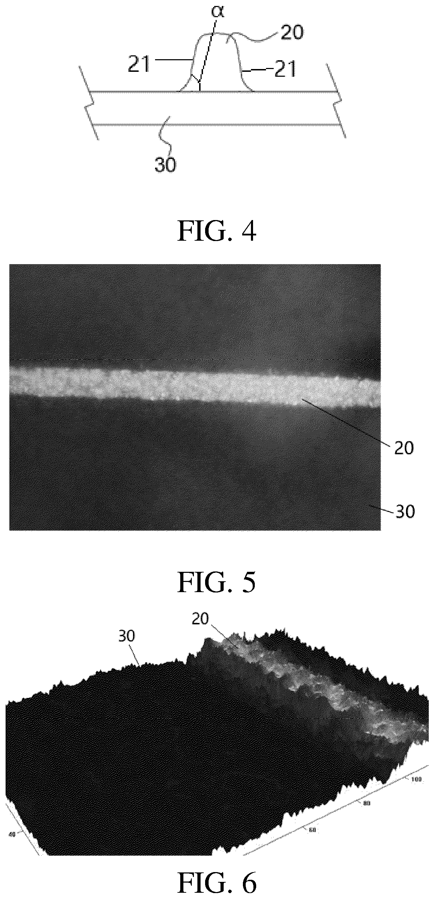

As shown in FIG. 5 to FIG. 7, the width of the collector electrode at any point on the collector electrode 20 may range from 5 µm to 30 µm, and the thickness of the collector electrode at any point on the collector electrode may range from 5 µm to 20 µm. Preferably, the width of the collector electrode at any point on the collector electrode 20 may range from 10 µm to 20 µm, and the thickness of the collector electrode at any point on the collector electrode may range from 8 µm to 12 µm. For example, the width of the collector electrode at any point on the collector electrode 20 may be 5 µm, 6 µm, 8 µm, 10 µm, 12 µm, 15 µm, 17 µm, 20 µm, 24 µm, 26 µm, 29 µm, 30 µm, or the like. The thickness of the collector electrode at any point on the collector electrode 20 may be 5 µm, 6 µm, 7 µm, 8 µm, 10 µm, 11 µm, 12 µm, 13 µm, 15 µm, 16 µm, 17 µm, 18 µm, 19 µm, 20 µm, or the like. Compared with the size of the collector electrode 20 obtained through the screen printing in the related art, the width of the collector electrode in the embodiments of this application is significantly reduced, so that the conversion efficiency can be improved based on the conversion efficiency of existing solar cells.

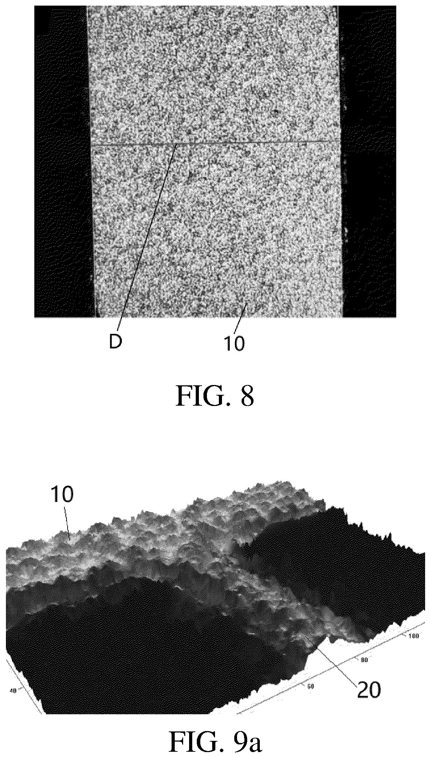

As shown in FIG. 8, a width D of the bus electrode at any point on the bus electrode 10 may range from 30 µm to 400 µm, and a thickness of the bus electrode at any point on the bus electrode may range from 3.4 µm to 29.4 µm. For example, the width D of the bus electrode at any point on the bus electrode 10 may be 30 µm, 50 µm, 100 µm, 130 µm, 150 µm, 170 µm, 200 µm, 250 µm, 270 µm, 300 µm, 330 µm, 360 µm, 370 µm, 390 µm, 400 µm, or the like. The thickness of the bus electrode at any point on the bus electrode 10 may be 3.4 µm, 5 µm, 6 µm, 8 µm, 10 µm, 13 µm, 15 µm, 17 µm, 19 µm, 20 µm, 24 µm, 25 µm, 27 µm, 28 µm, 29 µm, 29.4 µm, or the like.

As shown in FIG. 1, FIG. 6, and FIG. 7, a ratio of the thickness to the width of the collector electrode at any point on the collector electrode 20 ranges from 0.2 to 2. In this case, a narrow and high collector electrode 20 may be formed, so that a collector electrode 20 having a large cross-sectional area can be formed while a small width is ensured, thereby helping reduce the resistance of the collector electrode 20, and improving the conversion efficiency and the output power of the solar cell. In addition, the narrow and high collector electrode 20 in this application can provide certain reflection for the sunlight, so that an absorption rate of the cell 30 for the sunlight can be further improved. In addition, the thickness-to-width ratio falling within this range may ensure the structure stability of the electrode, thereby avoiding a problem of collapse of the electrode after long-time use. For example, the ratio of the thickness to the width of the collector electrode at any point on the collector electrode 20 may be 0.2, 0.22, 0.25, 0.28, 0.3, 0.4, 0.5, 0.6, 0.7, 0.8, 1, 1.1, 1.2, 1.3, 1.4, 1.5, 1.6, 1.7, 1.8, 1.9, 2, or the like.

During actual application, each collector electrode 20 includes a first section, a second section, and a third section that are consecutive, the second section is located between the first section and the third section, and a length of the second section of each collector electrode 20 accounts for 75% to 85% of a total length of the collector electrode 20; and a width error of the second section of each collector electrode 20 is less than or equal to 10%, where the width error is a percentage of a difference between the width of the collector electrode at any position on the collector electrode 20 and a width average value of a section in which the position is located to the width average value of the section. In this case, the width error of the second section of the collector electrode 20 is small, namely, a width error of a main body portion of the collector electrode 20 is small, and the width of the collector electrode is consistent, so that the resistance and stress sudden changes of the collector electrode 20 can be reduced, thereby ensuring constant stress and resistance of each collector electrode 20. For example, the width error of the second section of each collector electrode 20 may be 10%, 9%, 8%, 7%, 6%, 5%, 4%, 3%, 2%, 1%, 0%, or the like.

Further, the width error of the second section of each collector electrode 20 is less than or equal to 8%. In this case, the width error of the collector electrode 20 is further reduced, so that the precision of the collector electrode 20 can be further improved, ensuring constant stress and resistance of each collector electrode 20.

Further, a width error of each collector electrode 20 is less than or equal to 10%. In this case, for each collector electrode 20, both the main body portion (the second section) and the entire collector electrode 20 have a small width error. That is, the width of the entire collector electrode 20 is consistent. For example, the width error of each collector electrode 20 may be 10%, 9%, 8.5%, 8%, 7.5%, 7%, 6%, 5%, 4%, 3%, 2%, 1%, 0.5%, 0%, or the like.

Further, as shown in FIG. 1, widths of the collector electrode at all points on the collector electrode 20 may be the same. Specifically, the width of the entire collector electrode 20 remains consistent throughout the entire collector electrode, and particularly, a width of a part of the collector electrode 20 close to the bus electrode 10 is the same as those of other parts and is not narrowed. In this case, when the thickness of the collector electrode 20 remains unchanged, because the widths of the collector electrode at all the points on the collector electrode are the same, it may be ensured that the resistance and stress at all the points on the collector electrode 20 are consistent, thereby avoiding excessive current damage and uneven stress. Widths of the bus electrode at all points on the bus electrode 10 are the same. Specifically, the width of the entire bus electrode 10 remains consistent throughout the entire bus electrode, and particularly, a width of a junction with the collector electrode 20 is the same as those of other parts and is not narrowed. In this case, when the thickness of the bus electrode 10 remains unchanged, because the widths of the bus electrode at all the points on the bus electrode are the same, it may be ensured that the resistance and stress at all the points on the bus electrode 10 are consistent, thereby avoiding excessive current damage and uneven stress.

Specifically, as shown in FIG. 1, 3 bus electrodes 10 (A1, A2, and A3) on the cell 30 shown in FIG. 1 are selected, and widths of each bus electrode at 10 points on the bus electrode 10 are measured. Along a length direction of each bus electrode, the 10 points on the bus electrode 10 are uniformly distributed on the bus electrode 10.

As shown in FIG. 1, 3 collector electrodes 20 (B1, B2, and B3) on the cell 30 shown in FIG. 1 are selected, and widths of each collector electrode at 10 points on the collector electrode 20 are measured, where the 10 points on each collector electrode 10 are distributed along a length direction of the collector electrode. In addition, among the 10 points on the collector electrode B1, the third point to the eighth point fall within a section starting from 10% to 85% of a length of the collector electrode B1, namely, fall within a second section of the collector electrode B1 (the second section accounts for 75% of the total length). Among the 10 points on the collector electrode B2, the second point to the eighth point fall within a section starting from 10% to 90% of a length of the collector electrode B2, namely, fall within a second section of the collector electrode B2 (the second section accounts for 80% of the total length). Among the 10 points on the collector electrode B3, the second point to the ninth point fall within a section starting from 10% to 95% of a length of the collector electrode B3, namely, fall within a second section of the collector electrode B3 (the second section accounts for 85% of the total length).

In addition, 6 cells (not shown in the figure) are selected, and 1 collector electrode 20 is selected from each cell, namely, 6 collector electrodes 20 are selected, which are respectively denoted as C1, C2, C3, C4, C5, and C6. 6 points are selected from each collector electrode 20 for measuring thicknesses and widths of the collector electrode at the 6 points.

Through actual measurement, measurement results of widths of the bus electrodes A1, A2, and A3 are shown in Table 1; and measurement results of widths of the collector electrodes B1, B2, and B3 are shown in Table 2, and measurement results of thickness-to-width ratios of the collector electrodes C1 to C6 are shown in Table 3.

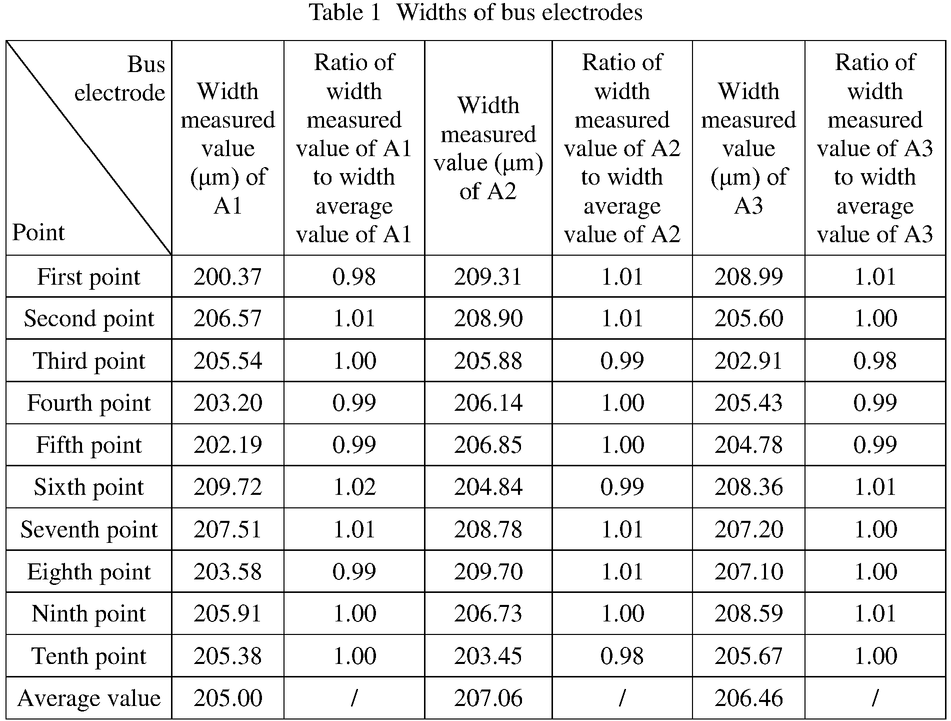

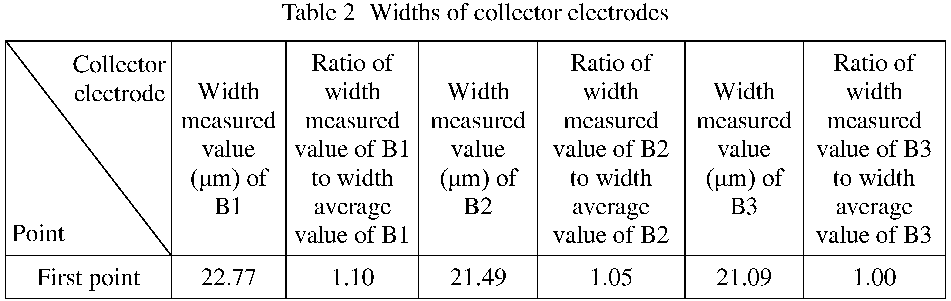

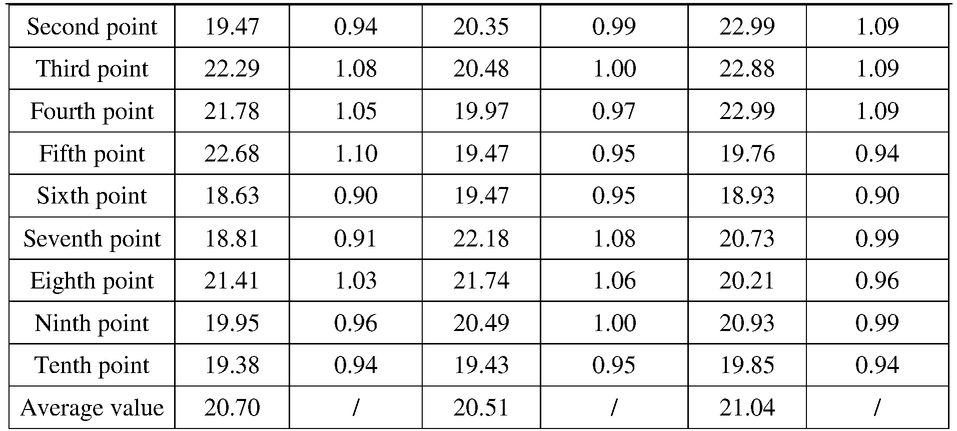

**Table 3 Thickness-to-width ratios of collector electrodes C1 to C6**

| Collector electrode | Point | Thickness measured value (µm) | Width measured value (µm) | Thickness-to-width ratio |
|---|---|---|---|---|
| C1 | First point | 9.32 | 19.39 | 0.48 |
| | Second point | 9.41 | 20.85 | 0.45 |
| | Third point | 9.75 | 18.84 | 0.52 |
| | Fourth point | 9.56 | 20.85 | 0.46 |
| | Fifth point | 9.36 | 18.53 | 0.51 |
| | Sixth point | 9.23 | 18.62 | 0.50 |
| C2 | First point | 11.42 | 9.39 | 1.22 |
| | Second point | 11.51 | 10.85 | 1.06 |
| | Third point | 10.75 | 9.28 | 1.16 |
| | Fourth point | 11.46 | 11.42 | 1.00 |
| | Fifth point | 11.36 | 10.53 | 1.08 |
| | Sixth point | 10.30 | 10.62 | 0.97 |
| C3 | First point | 4.32 | 16.39 | 0.26 |
| | Second point | 3.61 | 17.85 | 0.20 |
| | Third point | 3.75 | 17.84 | 0.21 |
| | Fourth point | 3.46 | 16.85 | 0.21 |
| | Fifth point | 3.40 | 16.53 | 0.21 |
| | Sixth point | 3.73 | 18.62 | 0.20 |
| C4 | First point | 8.21 | 28.85 | 0.28 |
| | Second point | 9.06 | 28.62 | 0.32 |
| | Third point | 7.22 | 29.53 | 0.24 |
| | Fourth point | 7.96 | 27.84 | 0.29 |
| | Fifth point | 8.07 | 29.96 | 0.27 |
| | Sixth point | 7.96 | 29.85 | 0.27 |
| C5 | First point | 29.28 | 15.39 | 1.90 |
| | Second point | 28.32 | 14.85 | 1.91 |
| | Third point | 28.74 | 16.84 | 1.71 |
| | Fourth point | 29.40 | 15.85 | 1.85 |
| | Fifth point | 28.27 | 16.53 | 1.71 |
| | Sixth point | 27.87 | 15.62 | 1.78 |
| C6 | First point | 11.12 | 5.68 | 1.96 |
| | Second point | 11.51 | 6.30 | 1.83 |
| | Third point | 10.3 | 5.15 | 2.00 |
| | Fourth point | 10.46 | 5.36 | 1.95 |
| | Fifth point | 10.94 | 6.25 | 1.75 |
| | Sixth point | 10.67 | 5.50 | 1.94 |

It may be learned from Table 1 that, widths of the three bus electrodes 10 A1 to A3 range from 200.31 µm to 209.72 µm, and a width error of each bus electrode 10 (the width error is a ratio of a difference between the width measured value and the width average value to the width average value) is less than or equal to 2%, where a maximum width error is 2%, and a minimum width error is 1%. It may be learned from Table 2 that, widths of the three collector electrodes 20 B1 to B3 range from 18.63 µm to 22.99 µm, and a width error of each collector electrode 20 is less than or equal to 10%, where a minimum width error is 3%, and a maximum width error is 10%. The width error at each point on each of the bus electrode 10 and the collector electrode 20 is less than or equal to 10%. It may be learned that, each of the bus electrode 10 and the collector electrode 20 in the embodiments of this application has a consistent width and a small width error.

It may be learned from Table 2 through analysis that, a width of the second section starting from the third point to the eight point of the collector electrode B1 ranges from 18.63 µm to 22.68 µm, and a width error of the second section ranges from 3% to 10%. It may be learned that, the width error of the second section of the collector electrode B1 may be less than or equal to 10%. A width of the second section starting from the second point to the eighth point of the collector electrode B2 ranges from 19.47 µm to 22.18 µm, and a width error of the second section ranges from 1% to 8%. It may be learned that, the width error of the second section of the collector electrode B2 may be less than or equal to 8%. A width of the second section starting from the second point to the ninth point of the collector electrode B3 ranges from 18.93 µm to 22.99 µm, and a width error of the second section ranges from 1% to 10%. It may be learned that, the width error of the second section of the collector electrode B3 may be less than or equal to 10%.

It may be learned from Table 3 that, a thickness-to-width ratio of the collector electrode C1 ranges from 0.46 to 0.52, a thickness-to-width ratio of the collector electrode C2 ranges from 0.97 to 1.22, a thickness-to-width ratio of the collector electrode C3 ranges from 0.2 to 0.26, a thickness-to-width ratio of the collector electrode C4 ranges from 0.24 to 0.32, a thickness-to-width ratio of the collector electrode C5 ranges from 1.71 to 1.91, and a thickness-to-width ratio of the collector electrode C6 ranges from 1.75 to 2. It may be learned that, the thickness-to-width ratio of each collector electrode in this application ranges from 0.2 to 2.

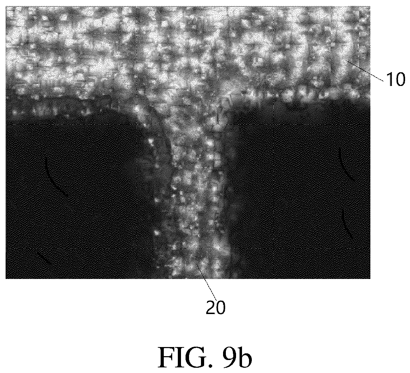

It may be learned from FIG. 6, FIG. 9a, and FIG. 9b that, the width of each collector electrode 10 is consistent, and the width of each bus electrode 20 is also consistent. The collector electrode 20 has a narrow and thick morphology, which helps reduce blocking to light, thereby increasing light reflection and improving the light absorption rate of the cell 30.

As shown in FIG. 2, the bus electrode 10 has a large width, and a cross-sectional shape of the bus electrode 10 may be a rectangle. As shown in FIG. 3a and FIG. 3b, the collector electrode 20 has a plurality of cross-sectional shapes, and during actual application, a corresponding cross-sectional shape may be selected according to a requirement of the solar cell. The cross-sectional shape of the collector electrode 20 is a shape of a cross section obtained by performing cutting on the collector electrode 20 along a direction perpendicular to a length direction of the collector electrode 20. In some embodiments, as shown in FIG. 3a, the cross-sectional shape of the collector electrode 20 may be a triangle. In this case, the triangular collector electrode 20 provides reflection for the incident sunlight, so that the collector electrode 20 has a light trapping function, and the absorption rate for the sunlight is improved. During specific implementation, the cross-sectional shape of the collector electrode 20 may be adjusted according to a width and a depth of each of the slits on the mask 50. By setting the mask 50 with a large thickness, within specified process time, the thick mask 50 provides great blocking to the electrode materials, thereby facilitating formation of the triangular collector electrode 20. A width-to-thickness ratio of the triangular collector electrode 20 may range from 1.8 to 2.2.

In some embodiments, as shown in FIG. 3b, the cross-sectional shape of the collector electrode 20 may be a trapezoid, and a top surface of the collector electrode 20 is an arc surface. The cross-sectional shape of the collector electrode 20 is similar to steamed bread. In this case, width changes at all the points on the collector electrode 20 are small, and material coverage is good, so that problems such as a gate with poor contact can be avoided. During specific implementation, compared with the triangular collector electrode 20, the collector electrode 20 with a steamed bread-shaped cross section may be formed by reducing the thickness of the mask 50 properly. A ratio of a thickness to a width of the collector electrode 20 may range from 0.8 to 1.2.

As shown in FIG. 4, an angle α exists between a side surface 21 of the collector electrode 20 and the cell 30 along a length direction of the collector electrode 20. In this case, the side surface 21 of the collector electrode 20 is inclined relative to the cell 30. The inclined side surface 21 of the collector electrode 20 can support the collector electrode 20, thereby improving the stability of the collector electrode 20. Especially, when the collector electrode 20 is narrow and thick, the stability of the collector electrode is relatively poor, and the inclined side surface 21 may assist in fixing the collector electrode 20, thereby improving the stability of the collector electrode and reducing a probability that the collector electrode 20 collapses.

As shown in FIG. 1, a gap exists between every two adjacent collector electrodes 20 along the same track, and a length of the gap ranges from 400 µm to 2000 µm. The length of the gap is a distance between two adjacent collector electrodes 20 along the same track. In this case, a coverage area of the collector electrode 20 on the cell 30 may be reduced, to improve the light absorption rate of the cell 30. For example, the length of the gap may be 400 µm, 500 µm, 600 µm, 700 µm, 800 µm, 900 µm, 1000 µm, 1100 µm, 1300 µm, 1500 µm, 1600 µm, 1800 µm, 1900 µm, 2000 µm, or the like.

An embodiment of this application further provides a solar cell. The solar cell includes the electrode of a solar cell described above. For beneficial effects of the solar cell, reference may be made to the beneficial effects of the electrode, and details are not described herein again.

Although this application has been described with reference to the embodiments herein, however, in a process of implementing this application claimed for protection, a person skilled in the art may understand and implement other variations of the embodiments of this application by viewing the accompanying drawings, the disclosed content, and the appended claims. In the claims, the term "comprising" does not exclude other components or steps, and the term "a" or "an" does not exclude a plurality. Some measures are recorded in dependent claims that are different from each other, but this does not mean that these measures cannot be combined to produce a better effect.

The foregoing described apparatus embodiments are merely examples. The units described as separate parts may or may not be physically separate, and the parts displayed as units may or may not be physical units, may be located in one position, or may be distributed on a plurality of network units. Some or all the modules may be selected according to an actual requirement to implement the objective of the solutions of the embodiments. A person of ordinary skill in the art may understand and implement this application without creative efforts.

"An embodiment", "embodiment", or "one or more embodiments" mentioned in the specification means that particular features, structures, or characteristics described with reference to the embodiment or embodiments may be comprised in at least one embodiment of this application. In addition, it should be noted that the term example "in an embodiment" herein does not necessarily indicate a same embodiment.

In the specification provided herein, a plurality of specific details are described. However, it can be understood that the embodiments of this application can be practiced without these specific details. In some examples, well-learned methods, structures, and technologies are not shown in detail so as not to obscure the understanding of this specification.

Finally, it should be noted that, the foregoing embodiments are only used for describing the technical solutions of this application rather than limiting this application. Although this application is described in detail with reference to the foregoing embodiments, a person of ordinary skill in the art should understand that modifications may be still made to the technical solutions described in the foregoing embodiments or equivalent replacements may be made to some technical features thereof. These modifications or replacements do not cause the essence of corresponding technical solutions to depart from the spirit and scope of the technical solutions in the embodiments of this application.

## Claims

1. An electrode of a solar cell, comprising a collector electrode and a bus electrode intersecting with each other, wherein a width of the collector electrode at any point on the collector electrode ranges from 5 µm to 30 µm; and a resistivity of each of the collector electrode and the bus electrode is less than or equal to 3×10⁻⁶ Ω·cm.

2. The electrode of a solar cell according to claim 1, wherein the width the collector electrode at any point on the collector electrode ranges from 10 µm to 20 µm; and a width of the bus electrode at any point on the bus electrode ranges from 30 µm to 400 µm.

3. The electrode of a solar cell according to claim 1, wherein a material of each of the collector electrode and the bus electrode comprises one or more of silver, aluminum, or copper.

4. The electrode of a solar cell according to claim 1, wherein a ratio of a thickness to the width of the collector electrode at any point on the collector electrode ranges from 0.2 to 2.

5. The electrode of a solar cell according to claim 1, wherein
each collector electrode comprises a first section, a second section, and a third section that are consecutive, the second section is located between the first section and the third section, and a length of the second section of each collector electrode accounts for 75% to 85% of a total length of the collector electrode; and a width error of the second section of each collector electrode is less than or equal to 10%, wherein
the width error is a percentage of a difference between a width of the collector electrode at any position on the collector electrode and a width average value of a section in which the position is located to the width average value of the section.

6. The electrode of a solar cell according to claim 5, wherein the width error of the second section of each collector electrode is less than or equal to 8%.

7. The electrode of a solar cell according to claim 5, wherein a width error of each collector electrode is less than or equal to 10%.

8. The electrode of a solar cell according to claim 5, wherein widths of the collector electrode at all points on the collector electrode are the same, and widths of the bus electrode at all points on the bus electrode are the same.

9. The electrode of a solar cell according to any one of claims 1 to 8, wherein a cross-sectional shape of the collector electrode is a triangle; or
a cross-sectional shape of the collector electrode is a trapezoid, and a top surface of the collector electrode is an arc surface.

10. The electrode of a solar cell according to any one of claims 1 to 8, wherein
an angle exists between a side surface of the collector electrode and a cell along a length direction of the collector electrode.

11. The electrode of a solar cell according to any one of claims 1 to 8, wherein a gap exists between every two adjacent collector electrodes along the same track, and a length of the gap ranges from 400 µm to 2000 µm.

12. The electrode of a solar cell according to any one of claims 1 to 8, wherein the electrode is prepared through a sputtering, evaporation, or deposition process after a mask is adhered to a cell.

13. A solar cell, comprising the electrode of a solar cell according to any one of claims 1 to 12.
